# EUROPÄISCHE PATENTSCHRIFT

(11) **EP 3 294 924 B1**
(45) Veröffentlichungstag und Bekanntmachung des Hinweises auf die Patenterteilung: **10.06.2020**
(21) Anmeldenummer: 16725352.5
(22) Anmeldetag: 13.04.2016
(51) Int. Cl.: C23C 28/04, C23C 16/26, C23C 16/02, C22C 35/00, C22C 19/00, C23C 28/00

(54) **SUBSTRAT MIT ZWISCHENÜBERZUG UND KOHLENSTOFFÜBERZUG**
SUBSTRATE COVERED WITH AN INTERMEDIATE COATING AND A CARBON COATING
SUBSTRAT RECOUVERT D'UN REVETEMENT INTERMEDIAIRE ET REVETEMENT DE CARBONE

(30) Priorität: 11.05.2015 DE 102015208644
(43) Veröffentlichungstag der Anmeldung: 21.03.2018
(73) Patentinhaber: Schaeffler Technologies AG & Co. KG, 91074 Herzogenaurach (DE)
(72) Erfinder: PROCELEWSKA, Joanna, 91058 Erlangen (DE); SCHULZ, Edgar, 91094 Langensendelbach (DE); MUSAYEV, Yashar, 90425 Nürnberg (DE)
(86) Internationale Anmeldenummer: PCT/DE2016/200182
(87) Internationale Veröffentlichungsnummer: WO 2016/180412

(56) Entgegenhaltungen:
- EP-A2- 1 251 192
- US-A- 5 538 799
- US-A1- 2003 094 869

## Beschreibung

Die vorliegende Erfindung betrifft ein Bauteil, umfassend ein Substrat mit mindestens einer Oberfläche, die mit einem Schichtsystem versehen ist, wobei das Schichtsystem mindestens eine amorphe Kohlenstoffschicht umfasst. Die vorliegende Erfindung betrifft auch eine Verwendung des Bauteils sowie ein Verfahren zur Herstellung des Bauteils.

Eingangs genannte Bauteile mit einem Schichtsystem finden in diversen technischen Gebieten Anwendung. So sind Schichtsysteme aus dem Stand der Technik bekannt, die tribologische Eigenschaften, wie z. B. Verschleißbeständigkeit oder Korrosionsbeständigkeit aufweisen, um für Hochleistungskomponenten, wie beispielsweise für hochbeanspruchte Kettentriebs-, Wälzlagerkomponenten, Motorenelemente und Werkzeuge, diese Eigenschaften zu gewährleisten.

Die CN 103046001 A beschreibt ein tribologisch wirksames Schichtsystem mit einer Titanschicht, einer Kohlenstoff-Titan-Übergangsschicht und einer amorphen Kohlenstoffschicht.

Patentdokumente US 5 538 799 A, EP 1 251 192 A2 und US 2003/094869 A1 beschreiben Haftvermittlerschichten für amorphe Kohlenstoffschichten.

Je nach Anwendungsfall bestehen diese Schichten aus einer Hartstoffschicht oder Kohlenstoffschicht, die mittels bekannter PVD oder PACVD Verfahren auf die Bauteile aufgebracht werden.

Das PVD oder PACVD Verfahren ist in vielen Bereichen der Technik bekannt und führt zu einer beachtlichen Verbesserung der tribologischen Eigenschaften, wie beispielsweise zu einer verbesserten Verschleißbeständigkeit und einer Reibungsreduzierung, der beschichteten Bauteile. Bei einer Anwendung in chemisch aggressiven Medien muss jedoch das Grundmaterial selber ausreichend korrosionsbeständig sein. Um eine Wirtschaftlichkeit zu erreichen, sind die Bauteile dann meist aus niedriglegierten, korrosionsbeständigen Werkstoffen hergestellt. Nachteiliger Weise reichen diese Technologien bei den Bauteilen zum einen jedoch nicht für einen sicheren Schutz gegen Verschleiß bei steigender Beanspruchung aus und zum anderen bieten sie keinen ausreichenden Korrosionsschutz in chemisch aggressiven Medien.

Eine Aufgabe der gegenwärtigen Erfindung ist daher, ein Bauteil, umfassend ein Substrat mit mindestens einer Oberfläche, die mit einem Schichtsystem versehen ist, wobei das Schichtsystem mindestens eine amorphe Kohlenstoffschicht umfasst, derart weiterzuentwickeln, dass dieses vor tribologischer Beanspruchung geschützt ist und insbesondere dabei einen sicheren und beständigen Verschleißschutz in einem chemisch aggressiven Umgebungsmedium gewährleistet.

Diese Aufgabe wird durch ein Bauteil gelöst, das die Merkmale gemäß Anspruch 1 aufweist. Das Bauteil ist korrosions- und verschleißbeständig und für Anwendungen mit extremer tribologischer Beanspruchung in chemisch aggressiven Umgebungsbedingungen geeignet.

Eine weitere Aufgabe der gegenwärtigen Erfindung ist, eine Verwendung eines solchen Bauteils anzugeben, so dass das Bauteil im Einsatz vor tribologischer Beanspruchung geschützt ist und insbesondere dabei einen sicheren und beständigen Verschleißschutz gewährleistet.

Diese Aufgabe wird durch eine Verwendung des erfindungsgemäßen Bauteils gelöst, die die Merkmale des Anspruchs 7 umfasst.

Eine weitere Aufgabe der gegenwärtigen Erfindung ist, ein serientaugliches, prozesssicheres und wirtschaftliches Verfahren zur Herstellung des Bauteils anzugeben.

Diese Aufgabe wird durch ein Verfahren zur Herstellung des erfindungsgemäßen Bauteils gelöst, das die Merkmale des Anspruchs 8 umfasst. Das danach gebildete Bauteil ist bei hoher tribologischer Beanspruchung im Einsatz sicher verwendbar und in chemisch aggressiven Umgebungsmedium beständig.

Das erfindungsgemäße Bauteil umfasst ein Substrat mit mindestens einer Oberfläche, die mit einem Schichtsystem versehen ist, wobei das Schichtsystem mindestens eine amorphe Kohlenstoffschicht umfasst. Das Schichtsystem weist weiterhin mindestens eine metallische Zwischenschicht auf, die zwischen dem Substrat und der mindestens einen amorphen Kohlenstoffschicht angeordnet ist. Die mindestens eine amorphe Kohlenstoffschicht bildet eine dem Substrat abgewandte äußere Schicht des Schichtsystems und umfasst mindestens eine amorphe wasserstoffhaltige Kohlenstoffschicht.

Die amorphe Kohlenstoffschicht bildet eine tribologisch funktionelle Schicht. Insbesondere ist die amorphe wasserstoffhaltige Kohlenstoffschicht, hier auch als a-C:H-Schicht bezeichnet, eine sogenannte DLC-Schicht (DLC = diamond-like carbon).

Bevorzugt weist die amorphe wasserstoffhaltige Kohlenstoffschicht einen Wasserstoffgehalt im Bereich von 10 bis 25 %, insbesondere von 15 bis 20 % auf. Dabei erfolgen hier und nachfolgend bei %-Angaben von Legierungsbestandteilen die Angaben in Atomprozent.

In einer bevorzugten Ausführungsform des erfindungsgemäßen Bauteils ist die amorphe wasserstoffhaltige Kohlenstoffschicht eine modifizierte wasserstoffhaltige amorphe Kohlenstoffschicht, die ein Dotierelement umfasst, das durch ein Metall oder ein Nichtmetall gebildet ist.

Metallhaltige amorphe wasserstoffhaltige Kohlenstoffschichten, hier auch als a-C:H:Me-Schichten bezeichnet, werden bevorzugt mit mindestens einem Dotierelement aus den Nebengruppen 4 bis 11 des Periodensystems gebildet. Durch Dotieren mit einem Metall, besitzt die amorphe Kohlenstoffschicht des Schichtsystems beispielsweise eine hohe Verschleißfestigkeit, einen geringen Reibkoeffizienten sowie ein verbessertes Haftvermögen an benachbarten Schichten. Durch eine Veränderung des Metallgehalts lassen sich die Materialeigenschaften des Schichtsystems stark beeinflussen.

Nichtmetalle enthaltende amorphe wasserstoffhaltige Kohlenstoffschichten, hier auch als a-C:H:X-Schichten bezeichnet, werden bevorzugt mit mindestens einem Dotierelement aus der Gruppe umfassend Silizium, Sauerstoff, Stickstoff, Fluor, Bor gebildet. Die Dotierung einer wasserstoffhaltigen amorphen Kohlenstoffschicht mit einem Nichtmetall ermöglicht es ebenfalls, die gewünschten Eigenschaften des Schichtsystems stark zu modifizieren. Silizium beispielsweise erhöht die Temperaturbeständigkeit in sauerstoffhaltiger Umgebung. Eine Dotierung mit Silizium und Sauerstoff kann die Oberflächenenergie stark herabsetzen (bis hin zu Werten in der Größenordnung von PTFE). Außerdem lassen sich transparente und äußerst kratzfeste Schichten herstellen.

Eine weitere Ausführungsform des erfindungsgemäßen Bauteils kann auch vorsehen, dass die mindestens eine amorphe Kohlenstoffschicht zwei amorphe Kohlenstoffschichten umfasst, wobei eine erste amorphe wasserstoffhaltige Kohlenstoffschicht und eine weitere modifizierte amorphe wasserstoffhaltige Kohlenstoffschicht mit Dotierelementen vorhanden sind. Dabei kann die erste oder die zweite Kohlenstoffschicht die äußere Schicht des Schichtsystems bilden.

Erfindungsgemäß besteht die mindestens eine metallische Zwischenschicht aus Titan, einer Titanlegierung, Nickel oder einer Nickellegierungen. Insbesondere ist eine Zwischenschicht aus einer Titan-Nickel-Legierung oder einer Titan-Nickel-Vanadium-Legierung gebildet.

Somit werden die guten tribologischen Eigenschaften einer z. B. PVD-Beschichtung in Kombination mit einer titan- und/oder nickellegierten Zwischenschicht genutzt, um tribologisch hochbelastete Bauteile in aggressiven Umgebungsmedium ausrüsten zu können. Durch gezielte Abscheideverfahren werden die Anteile der Legierungspartner erzielt (z. B. Titan/Nickel 40/60 %). Durch den Einsatz zusätzlicher Simulationstools wird hier die optimale Schichtzusammensetzung ermittelt, welche je nach tribologischem System ein höchstes Maß an Korrosionsschutz gewährleistet.

Vorzugsweise liegt eine Gesamtschichtdicke D des Schichtsystems im Bereich von 2 bis 100 µm, insbesondere von 2 bis 50 µm, besonders bevorzugt von 2 bis 25 µm.

In einer bevorzugten Ausführungsform des Bauteils ist weiterhin mindestens eine Haftvermittlerschicht vorhanden, die zwischen der mindestens einen Zwischenschicht und dem Substrat angeordnet ist. Die Haftvermittlerschicht kann die Haftung der Zwischenschicht verbessern, die Haltbarkeit des Schichtsystems und/oder die Korrosionsbeständigkeit des Bauteils verbessern. Die mindestens eine Haftvermittlerschicht ist dabei bevorzugt aus einem Metall oder einer Metalllegierung gebildet, wobei eine Zusammensetzung der mindestens einen Haftvermittlerschicht sich von einer Zusammensetzung der mindestens einen Zwischenschicht unterscheidet.

Das Substrat des Bauteils wird insbesondere aus Stahl, insbesondere vergütetem Stahl gebildet.

In einem solchen Fall haben sich als Haftvermittlerschicht insbesondere Nickellegierungen, vorzugsweise Nickel-Chrom-Legierungen oder Nickel-Vanadium-Legierungen, bewährt. Diese Zusammensetzungen dienen vor allem der Verbesserung der Haftung des Schichtsystems auf der Oberfläche des Substrats. Weiterhin hat sich als Haftvermittlerschicht auch eine Nickel-Phosphor-Legierung bewährt. Die Nickel-Phosphor-Legierung (NiP) weist dabei vorzugsweise einen Phosphor-Gehalt von größer 10 %, vorzugsweise im Bereich von 12 bis 15 % auf. Insbesondere wird dabei eine amorphe NiP-Schicht ausgebildet. Derartige Haftvermittlerschichten aus NiP dienen weniger einer Haftvermittlung als einen zusätzlichen Korrosionsschutz des Substrats.

Erfindungsgemäß ist eine mindestens zweischichtig aufgebaute Haftvermittlerschicht vorhanden, die angrenzend an das Substrat eine erste Haftvermittlerschicht aus NiP und darauf eine zweite Haftvermittlerschicht aus einer Nickel-Chrom-Legierungen oder Nickel-Vanadium-Legierungen aufweist, die an die Zwischenschicht angrenzt. Diese mehrschichtige Haftvermittlerschicht gewährleistet eine gute Haftung des Schichtsystems am Substrat und gleichzeitig eine Verbesserung des Korrosionsschutzes für das Substrat.

Ein Bauteil umfassend ein Substrat aus Stahl und ein Schichtsystem, wobei das Schichtsystem ausgehend vom Substrat in dieser Reihenfolge eine optionale metallische Haftvermittlerschicht aus NiV oder NiCr aufweist, eine metallische Zwischenschicht aus einer Titan-Nickel-Legierung, insbesondere einer Titan-Nickel-Chrom-Legierung oder einer Titan-Nickel-Vanadium-Legierung, aufweist und eine amorphe wasserstoffhaltige Kohlenstoffschicht aufweist, hat sich als korrosions- und verschleißresistent erwiesen.

Ein Bauteil umfassend ein Substrat aus Stahl und ein Schichtsystem, wobei das Schichtsystem ausgehend vom Substrat in dieser Reihenfolge eine mehrschichtige Haftvermittlerschicht aus einer ersten Haftvermittlerschicht aus NiP und einer zweiten Haftvermittlerschicht aus NiV oder NiCr aufweist, eine metallische Zwischenschicht aus einer Titan-Nickel-Legierung, insbesondere einer Titan-Nickel-Chrom-Legierung oder einer Titan-Nickel-Vanadium-Legierung, aufweist und eine amorphe wasserstoffhaltige Kohlenstoffschicht aufweist, hat sich als besonders korrosions- und verschleißresistent erwiesen.

Das erfindungsgemäße Verfahren zur Herstellung eines erfindungsgemäßen Bauteils, zeichnet sich durch die folgenden Schritte aus:
- Abscheiden der zweischichtigen Haftvermittlerschicht;
- Abscheiden der mindestens einen metallischen Zwischenschicht auf die zweischichtige Haftvermittlerschicht; und
- Abscheiden der mindestens einen amorphen Kohlenstoffschicht umfassend die mindestens eine amorphe wasserstoffhaltige Kohlenstoffschicht auf die mindestens eine metallische Zwischenschicht.

Bevorzugt werden die mindestens eine optionale Haftvermittlerschicht und/oder die mindestens eine metallische Zwischenschicht und/oder die mindestens eine amorphe Kohlenstoffschicht umfassend die mindestens eine amorphe wasserstoffhaltige Kohlenstoffschicht mittels PVD oder PACVD abgeschieden.

Alternativ werden die mindestens eine metallische Zwischenschicht, gegebenenfalls weiterhin die mindestens eine optionale Haftvermittlerschicht, mittels einer galvanischen Abscheidung und/oder mittels eines thermischen Spritzens abgeschieden und weiterhin die mindestens eine amorphe Kohlenstoffschicht umfassend die mindestens eine amorphe wasserstoffhaltige Kohlenstoffschicht mittels PVD oder PACVD abgeschieden.

Eine erste bevorzugte Ausführungsform des erfindungsgemäßen Verfahrens kann auch vorsehen, dass die metallische Zwischenschicht aus Titan, einer Titanlegierung, Nickel oder einer Nickellegierung besteht, die durch einzelne Targets und/oder Mosaik-Targets mittels PVD oder PACVD auf das Substrat aufgebracht wird.

Das Bauteil umfassend das zuvor beschriebene Schichtsystem, umfassend mindestens eine amorphe wasserstoffhaltige Kohlenstoffschicht, bringt hervorragende tribologische Eigenschaften mit sich. Zudem gewährleistet dieses Schichtsystem neben einem sicheren und beständigen Verschleißschutz für das Bauteil auch aufgrund der mindestens einen metallischen Zwischenschicht, gegebenenfalls auf mindestens einer Haftvermittlerschicht, einen Korrosionsschutz in einem chemisch aggressiven Umgebungsmedium. Unter einem chemisch aggressiven Umgebungsmedium werden dabei beispielsweise Kohlenwasserstoffe, Lösungsmittel, organische Lösungen, Meerwasser, Säuren, Laugen, usw. verstanden.

Somit kann die Erfindung auch für hochbeanspruchte Maschinenelemente angewandt werden. Dazu gehören beispielsweise Wellen oder Wälzlager, die einem chemisch aggressiven Umgebungsmedium ausgesetzt sind. Ebenso kann die Erfindung auch für spezielle Anwendungen, die besondere Anforderungen an die Oberflächen stellen, wie bei Vorliegen einer Mangelschmierung oder einem Medieneintritt bei einem Wälzlager, insbesondere in der Lebensmittel- oder Pharmaindustrie, bei Lagerungen für Dentalbohrer, Turboladern, Spindellagern, Pumpen, Unterwasserturbinen o. ä., herangezogen werden. Ein weiterer Vorteil der Erfindung besteht darin, dass die hier beschriebenen Schichtsysteme aus anlagentechnischer (z. B: In-Line Anlage) und prozesstechnischer Sicht entsprechend leicht und wirtschaftlich realisierbar sind, so dass mittels des erfindungsgemäßen Verfahrens eine serientaugliche und prozesssichere Herstellung eines korrosions- und verschleißbeständigen Bauteils möglich ist.

Im Folgenden sollen Ausführungsbeispiele die Erfindung und ihre Vorteile anhand der beigefügten Figur näher erläutern. Die Größenverhältnisse in der Figur entsprechen nicht den realen Größenverhältnissen, da die Schichten des Schichtsystems in einer Explosionsdarstellung vereinzelt und vereinfacht dargestellt sind. Dabei zeigt:

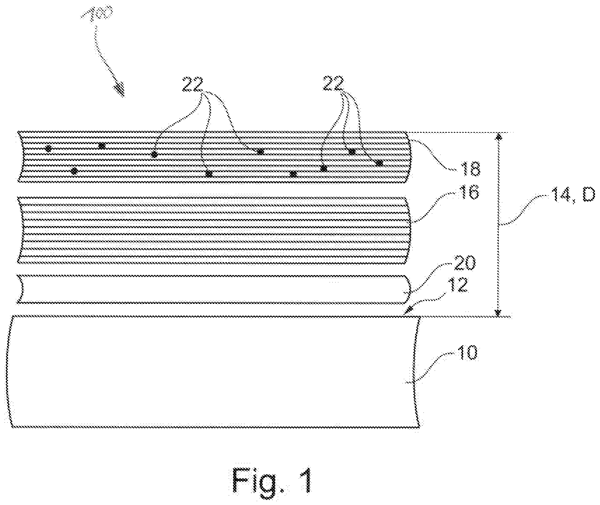

- Fig. 1: eine teilweise Schnittansicht eines Bauteils, bei dem eine Oberfläche des Substrats mit einem Schichtsystem gemäß der Erfindung versehen ist.

**Figur 1** zeigt eine teilweise Schnittansicht eines Bauteils 100, das ein Substrat 10 aus Stahl und ein Schichtsystem 14 umfasst. Eine Oberfläche 12 des Substrats 10 ist mit dem erfindungsgemäßen Schichtsystem 14 versehen, wobei hier eine direkt auf die Oberfläche 12 des Substrats 10 aufgebrachte Haftvermittlerschicht 20 dargestellt ist. Dabei ist die Haftvermittlerschicht 20 lediglich optional vorhanden und nicht zwingend erforderlich. Weiterhin ist eine metallische Zwischenschicht 16 vorhanden, die direkt auf der Oberfläche 12 des Substrats 10 oder auf die optional vorhandene Haftvermittlerschicht 20 aufgebracht ist. Weiterhin ist eine äußere Schicht 18 in Form einer tribologisch funktionellen, amorphen wasserstoffhaltigen Kohlenstoffschicht vorhanden, welche dem Substrat 10 abgewandt angeordnet ist. Die metallische Haftvermittlerschicht besteht hier beispielsweise aus einer Nickel-Vanadium-Legierung. Die Haftvermittlerschicht kann aber auch mehrschichtig aufgebaut sein und insbesondere eine erste Haftvermittlerschicht, beispielsweise aus NiP, und eine zweite Haftvermittlerschicht, beispielsweise aus NiCr, umfassen.

Die metallische Zwischenschicht 16 besteht vorzugsweise aus Titan, einer Titanlegierung, Nickel oder einer Nickellegierungen. Hier wird eine Zwischenschicht 16 aus einer Titan-Nickel-Vanadium-Legierung eingesetzt. Bei der Herstellung der Schichten des Schichtsystems 14 mittels PVD oder PACVD können einzelne Targets wie auch sogenannte Mosaik-Targets verwendet werden. Die tribologisch funktionelle amorphe wasserstoffhaltige Kohlenstoffschicht ist in einer Ausführungsform eine modifizierte wasserstoffhaltige amorphe Kohlenstoffschicht. Das auf dem Bauteil 100 gebildete Schichtsystem 14 weist hier eine Gesamtschichtdicke D von 25 µm auf.

Die dargestellte Ausführungsform des Bauteils stellt lediglich ein Beispiel dar, wie das erfindungsgemäße Bauteil sowie das erfindungsgemäße Verfahren zur Herstellung ausgestaltet sein können. Weiterhin können mehrere metallische Zwischenschichten vorhanden sein. Schließlich können auch mehrere amorphe Kohlenstoffschichten umfassend mindestens eine amorphe wasserstoffhaltige Kohlenstoffschicht vorhanden sein.

### Bezugszeichenliste

- 100: Bauteil
- 10: Substrat
- 12: Oberfläche
- 14: Schichtsystem
- 16: metallische Zwischenschicht
- 18: äußere Schicht
- 20: Haftvermittlerschicht
- 22: Dotierelement
- D: Gesamtschichtdicke

## Patentansprüche

1. Bauteil (100), umfassend ein Substrat (10) mit mindestens einer Oberfläche (12), die mit einem Schichtsystem (14) versehen ist, wobei das Schichtsystem (14) mindestens eine amorphe Kohlenstoffschicht umfasst, wobei das Schichtsystem (14) weiterhin mindestens eine metallische Zwischenschicht (16) umfasst, die zwischen dem Substrat (10) und der mindestens einen amorphen Kohlenstoffschicht angeordnet ist, wobei die metallische Zwischenschicht (16) aus Titan, einer Titanlegierung, Nickel oder einer Nickellegierung besteht, wobei weiterhin eine zweischichtige Haftvermittlerschicht (20) vorhanden ist, die zwischen der mindestens einen Zwischenschicht (16) und dem Substrat (10) angeordnet ist, wobei eine erste Haftvermittlerschicht aus NiP und darauf eine zweite Haftvermittlerschicht aus einer Nickel-Chrom-Legierung oder einer Nickel-Vanadium-Legierung vorhanden ist, und wobei die mindestens eine amorphe Kohlenstoffschicht eine dem Substrat (10) abgewandte äußere Schicht (18) des Schichtsystems (14) bildet und mindestens eine amorphe wasserstoffhaltige Kohlenstoffschicht umfasst.

2. Bauteil (100) nach Anspruch 1, wobei die mindestens eine amorphe wasserstoffhaltige Kohlenstoffschicht ein Dotierelement (22) umfasst, das durch ein Metall oder ein Nichtmetall gebildet ist.

3. Bauteil (100) nach Anspruch 1 oder Anspruch 2, wobei die amorphe wasserstoffhaltige Kohlenstoffschicht einen Wasserstoffgehalt im Bereich von 10 bis 25 at.-% aufweist.

4. Bauteil (100) nach einem der vorangehenden Ansprüche, wobei eine Gesamtschichtdicke (D) des Schichtsystems (14) im Bereich von 2 µm bis 100 µm liegt.

5. Bauteil (100) nach einem der vorangehenden Ansprüche,. wobei das Substrat (10) aus Stahl gebildet ist.

6. Bauteil (100) nach einem der Ansprüche 1 bis 5, wobei die metallische Zwischenschicht (16) aus einer Titan-Nickel-Legierung gebildet ist.

7. Verwendung eines Bauteils (100) nach einem der Ansprüche 1 bis 6, wobei das Bauteil (100) zumindest im Bereich des Schichtsystems (14) mit einem Reibpartner in einem chemisch aggressiven Umgebungsmedium zusammenwirkt.

8. Verfahren zur Herstellung eines Bauteils (100) nach einem der Ansprüche 1 bis 6, **gekennzeichnet durch** die folgenden Schritte:
- Abscheiden der zweischichtigen Haftvermittler schicht (20);
- Abscheiden der mindestens einen metallischen Zwischenschicht (16) auf die zweischichtige Haftvermittlerschicht (20); und
- Abscheiden der mindestens einen amorphen Kohlenstoffschicht umfassend die mindestens eine amorphe wasserstoffhaltige Kohlenstoffschicht auf die mindestens eine metallische Zwischenschicht (16).

9. Verfahren nach Anspruch 8, wobei die zweischichtige Haftvermittlerschicht (20) und/oder die mindestens eine metallische Zwischenschicht (16) und/oder die mindestens eine amorphe Kohlenstoffschicht umfassend die mindestens eine amorphe wasserstoffhaltige Kohlenstoffschicht mittels PVD oder PACVD abgeschieden werden.

10. Verfahren nach Anspruch 8,wobei die mindestens eine metallische Zwischenschicht (16), gegebenenfalls weiterhin die zweischichtige Haftvermittlerschicht (20), mittels einer galvanischen Abscheidung und/oder mittels eines thermischen Spritzens abgeschieden wird und wobei die mindestens eine amorphe Kohlenstoffschicht umfassend die mindestens eine amorphe wasserstoffhaltige Kohlenstoffschicht mittels PVD oder PACVD abgeschieden wird.

## Claims

1. A component (100) comprising a substrate (10) having at least one surface (12) which is provided with a layer system (14), wherein the layer system (14) comprises at least one amorphous carbon layer, wherein
the layer system (14) further comprises at least one metal intermediate layer (16) which is arranged between the substrate (10) and the at least one amorphous carbon layer, wherein the metal intermediate layer (16) consists of titanium, a titanium alloy, nickel or a nickel alloy, wherein there is furthermore a two-layer adhesion promoter layer (20) which is arranged between the at least one intermediate layer (16) and the substrate (10), wherein a first adhesion promoter layer made of NiP and a second adhesion promoter layer thereon made of a nickel-chromium alloy or a nickel-vanadium alloy is present, and
wherein the at least one amorphous carbon layer forms an outer layer (18) of the layer system (14) facing away from the substrate (10) and comprises at least one amorphous hydrogen-containing carbon layer.

2. The component (100) according to claim 1, wherein the at least one amorphous hydrogen-containing carbon layer comprises a doping element (22) which is formed by a metal or a non-metal.

3. The component (100) according to claim 1 or claim 2, wherein the amorphous hydrogen-containing carbon layer has a hydrogen content in the range from 10 to 25 atomic %.

4. The component (100) according to any one of the preceding claims, wherein a total layer thickness (D) of the layer system (14) is in the range from 2 µm to 100 µm.

5. The component (100) according to any one of the preceding claims, wherein the substrate (10) is made of steel.

6. The component (100) according to any one of claims 1 to 5, wherein the metal intermediate layer (16) is made of a titanium-nickel alloy.

7. A use of a component (100) according to any one of claims 1 to 6, wherein the component (100) interacts at least in the region of the layer system (14) with a friction partner in a chemically aggressive ambient medium.

8. A method for producing a component (100) according to any one of claims 1 to 6, **characterised by** the following steps:
- Depositing the two-layer adhesion promoter layer (20);
- Depositing the at least one metal intermediate layer (16) onto the two-layer adhesion promoter layer (20); and
- Depositing the at least one amorphous carbon layer comprising the at least one amorphous hydrogen-containing carbon layer on the at least one metal intermediate layer (16).

9. The method according to claim 8, wherein the two-layer adhesion promoter layer (20) and/or the at least one metal intermediate layer (16) and/or the at least one amorphous carbon layer comprising the at least one amorphous hydrogen-containing carbon layer are deposited by means of PVD or PACVD

10. The method according to claim 8, wherein the at least one metal intermediate layer (16), optionally also the two-layer adhesion promoter layer (20), is deposited by means of a galvanic deposition and/or by means of thermal spraying, and wherein the at least one amorphous carbon layer comprising the at least one amorphous hydrogen-containing carbon layer is deposited by means of PVD or PACVD

## Revendications

1. Composant (100) comprenant un substrat (10) présentant au moins une surface (12) qui est pourvue d'un système de couches (14), le système de couches (14) comprenant au moins une couche de carbone amorphe,
le système de couches (14) comprenant en outre au moins une couche intermédiaire métallique (16) qui est disposée entre le substrat (10) et la au moins une couche de carbone amorphe, la couche intermédiaire métallique (16) étant constituée de titane, d'un alliage de titane, de nickel ou d'un alliage de nickel, une couche de promoteur d'adhérence à deux couches (20) étant également disposée entre la au moins une couche intermédiaire (16) et le substrat (10), une première couche de promoteur d'adhérence en NiP et sur celle-ci une seconde couche de promoteur d'adhérence en alliage nickel-chrome ou en alliage nickel-vanadium étant prévues et
la au moins une couche de carbone amorphe formant une couche extérieure (18) du système de couches (14) orientée à l'opposé du substrat (10) et comprenant au moins une couche de carbone amorphe contenant de l'hydrogène.

2. Composant (100) selon la revendication 1, la au moins une couche de carbone amorphe contenant de l'hydrogène comprenant un élément dopant (22) qui est formé par un métal ou un non-métal.

3. Composant (100) selon la revendication 1 ou la revendication 2, la couche de carbone amorphe contenant de l'hydrogène ayant une teneur en hydrogène dans la plage comprise entre 10 et 25 % at..

4. Composant (100) selon l'une quelconque des revendications précédentes, une épaisseur totale de couche (D) du système de couches (14) se trouvant dans la plage comprise entre 2 µm et 100 µm.

5. Composant (100) selon l'une quelconque des revendications précédentes, le substrat (10) étant constitué d'acier.

6. Composant (100) selon l'une quelconque des revendications 1 à 5, la couche intermédiaire métallique (16) étant constituée d'un alliage titane-nickel.

7. Utilisation d'un composant (100) selon l'une quelconque des revendications 1 à 6, le composant (100) coopérant au moins dans la région du système de couches (14) avec un élément de friction dans un milieu ambiant chimiquement agressif.

8. Procédé de fabrication d'un composant (100) selon l'une quelconque des revendications 1 à 6, **caractérisé par** les étapes suivantes :
- dépôt de la couche de promoteur d'adhérence à deux couches (20) ;
- dépôt de la au moins une couche intermédiaire métallique (16) sur la couche de promoteur d'adhérence à deux couches (20) ; et
- dépôt de la au moins une couche de carbone amorphe comprenant la au moins une couche de carbone amorphe contenant de l'hydrogène sur la au moins une couche intermédiaire métallique (16).

9. Procédé selon la revendication 8, la couche de promoteur d'adhérence à deux couches (20) et/ou la au moins une couche intermédiaire métallique (16) et/ou la au moins une couche de carbone amorphe comprenant la au moins une couche de carbone amorphe contenant de l'hydrogène étant déposées par PVD ou PACVD

10. Procédé selon la revendication 8, la au moins une couche intermédiaire métallique (16), éventuellement aussi la couche de promoteur d'adhérence à deux couches (20), étant déposées par dépôt galvanique et/ou par projection thermique et la au moins une couche de carbone amorphe comprenant la au moins une couche de carbone amorphe contenant de l'hydrogène étant déposée par PVD ou PACVD
